# EUROPEAN PATENT SPECIFICATION

(11) **EP 1 837 418 B1**
(45) Date of publication and mention of the grant of the patent: **24.08.2011**
(21) Application number: 07001530.0
(22) Date of filing: 24.01.2007
(51) Int. Cl.: C23C 30/00, C23C 14/06, C23C 14/35, C23C 14/46

(54) **Slide member having a high-hardness carbon coating**
GLEITELEMENT mit einer Kohlenstoffbeschichtung von hoher Härte
ÉLÉMENT COULISSANT avec un revêtement en carbone à dureté élevée

(30) Priority: 20.03.2006 JP 2006075881
(43) Date of publication of application: 26.09.2007
(73) Proprietor: HITACHI, LTD., Chiyoda-ku Tokyo 100-8280 (JP)
(72) Inventor: Okamoto, Shinya, c/o Hitachi, Ltd., 6-1, Marunouchi 1-chome, Chiyoda-ku, Tokyo 100-8220 (JP); Nakashima, Shoichi, c/o Hitachi, Ltd., 6-1, Marunouchi 1-chome, Chiyoda-ku, Tokyo 100-8220 (JP); Baba, Noboru, c/o Hitachi, Ltd., 6-1, Marunouchi 1-chome, Chiyoda-ku, Tokyo 100-8220 (JP); Yamaguchi, Shizuka, c/o Hitachi, Ltd., 6-1, Marunouchi 1-chome, Chiyoda-ku, Tokyo 100-8220 (JP)
(74) Representative: Strehl Schübel-Hopf & Partner

(56) References cited:
- WO-A-00/68455
- WO-A-94/12680
- JP-A- 63 186 417
- JP-A- 2001 316 686
- JP-A- 2004 204 311
- JP-A- 2004 277 782
- US-A- 5 763 087
- US-A1- 2004 191 153

## Description

### Field of the Invention

The present invention relates to a high-hardness carbon coating of low friction useful for slide members working under an unlubricated condition, in the presence of water, organic solvent or fuel, or under an oil-lubricated condition.

### Background of the Invention

High-hardness carbon coatings generally have a high hardness, flat and smooth surfaces, excellent friction resistance, and low friction coefficient and excellent low friction characteristics coming from their solid lubricity.

Their surface friction coefficient is about 0.12, comparing with 0.5 to 1.0 of common steel of flat/smooth surfaces, and about 0.4 of surface treatment materials, e.g., Ni-P and Cr plating materials, TiN and CrN coatings, and so forth.

They are being applied to slide members or the like working under an unlubricated condition with these excellent characteristics, e.g., cutting instruments, beginning with drill blades, jigs for machining gliding tools, dies for deforming processes, valve cocks, capstan rolls and so forth.

Lubricated sliding is now prevailing for machine components in combustion engines and the like, which are required to reduce mechanical loss as far as possible for energy saving and environmental reasons. However, it is preferable should slide members with a high-hardness carbon coating exhibiting solid lubricity can have reduced friction under an unlubricated condition, because load on machine components can be reduced even when lubrication oil for these members is depleted. Unlubricated sliding is also preferable for global environments, because it can reduce lubrication oil consumption in the future.

Patent Document 1 discloses a technique for reducing solid lubricity of lubricant oil by incorporating a high-hardness carbon coating with a metal at 5 to 70% by atom.Patent Document 1: JP-A-2001-316686

WO 00/68455 A discloses sliding members coated with a hard carbon coating.

JP 2004 204311 A discloses sliding members which are coated with Cr and CrC coatings.

JP 63 186417 A describes the formation of a semiconductor carbon thin film.

US-A-5 763 087 shows another example of a diamond-like carbon coating on a substrate according to the prior art.

### Brief Summary of the Invention

Patent Document 1, however, makes no mention of breaking away of high-hardness carbon coating from a slide member working under an unlubricated condition due to a loading on the member. Therefore, the conventional technique involves problems that a high-hardness carbon coating cannot fully exhibit its inherent friction resistance characteristics under an unlubricated condition.

It is an object of the present invention to provide a high-hardness carbon coating which can exhibit its inherent friction resistance characteristics.

The object is met by the slide member of claim 2 and the method of claim 1.

The high-hardness carbon coating of the slide member contains an aluminum element at 0.5 to 4.5% by atom. In particular, aluminum is preferably present both in the surface layer and inside. The coating preferably has a Young's modulus of 50 to 180 GPa.

The high-hardness carbon coating preferably has a thickness of 0.5 to 10.0 µm, and a surface roughness of 0.1 µm or less.

The high-hardness carbon coating is produced by unbalanced magnetron sputtering.

The aluminum element is present in the coating surface layer in the form of aluminum oxide and/or aluminum hydroxide.

The substrate is preferably of a metal alloy containing Fe, Cr and Mo, and the alloy is preferably additionally coated with a Cr layer, more preferably further with a Cr/C layer in which Cr and C are mixed with each other.

The Carbon for the high-hardness carbon coating is preferably a mixture of sp² and sp³ combined (bonded) carbon species.

Other objects, features and advantages of the invention will become apparent from the following description of the embodiments of the invention taken in conjunction with the accompanying drawings.

### Brief Description of the Drawings

Figure 1 is an oblique view illustrating a test piece composed of a circular substrate coated with a high-hardness carbon coating.
Figure 2 is a cross-sectional view illustrating a rubbing tester used for evaluation of the present invention.
Figure 3 is an oblique view illustrating in a rubbing tester (test piece-ball sliding area) used for evaluation of the present invention.
Figure 4 illustrates a simulated tester (simulation tester) for vehicle lifter at valve operating system.

### (Description of Reference Numerals)

1: Test piece, 2: Circular substrate, 3: High-hardness carbon coating, 11: Abrasion tester, 12: Rotating shaft, 13: Work table, 14: Metallic ball, 15: Spring, 16: Holder, 17: Motor, 18: Load cell, 21: Simulated tester, 22: Vehicle lifter at valve operating system, 23: Crest surface, 24: Cam, 25: Engine oil

### Detailed Description of the Invention

The present invention is described in detail by Examples, which by no means limit the present invention.

The high-hardness carbon coating of the present invention is applicable to slide members as machine components and the like working under an unlubricated condition.

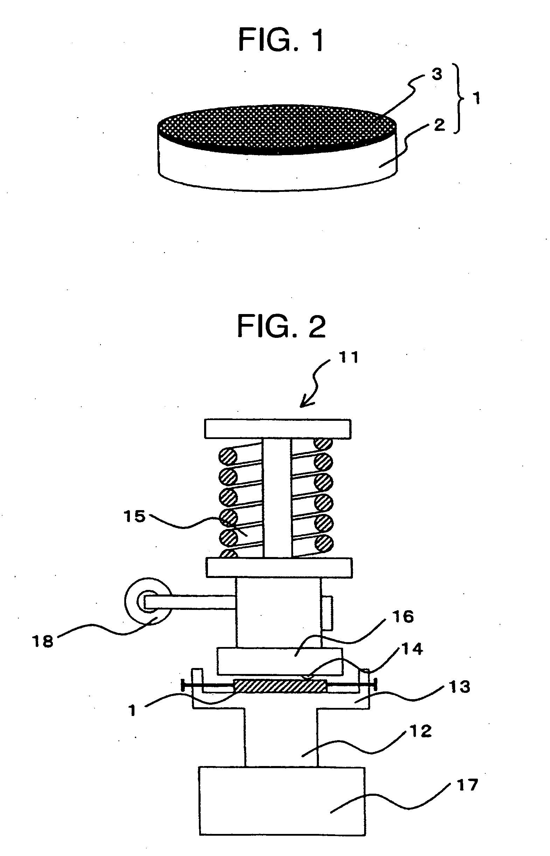

Referring to Figure 1, a test piece 1 composed of a circular substrate 2 (diameter: 21.5 mm and thickness: 5.2 mm) coated with a high-hardness carbon coating 3 was rubbing-tested.

Table 1 gives specifications (coating treatment, coating method, Al content and coating thickness) under which the test piece 1 was prepared by coating the circular substrate 2 with the high-hardness carbon coating 3.

The high-hardness carbon coating 3 was of diamond-like-carbon (DLC) formed on the circular substrate 2 by unbalanced magnetron sputtering (UBM sputtering).

The UBM sputtering coating method intentionally adopts unbalanced arrangement of magnetic poles set at the center and on the periphery of target back surface, to extend part of magnetic lines from the periphery to the substrate, thereby facilitating the plasma converging in the target vicinity to run along the magnetic lines to the substrate vicinity. This allows the substrate to be irradiated with a larger quantity of ions in the coating process, to form a denser coating on the substrate.

The test piece 1 with the high-hardness carbon coating 3 was evaluated by nano-indentation (ISO14577) and a rubbing test for the coating surface.

The nano-indentation method (ISO14577) was carried out with an indenter (Berkovich triangular pyramid having a ridge angle of 115°) pressed into the high-hardness carbon coating 3 surface for 10 seconds at a load of 3 mN at the highest, at which it was held for 1 second, and then removed taking 10 seconds.

Young's modulus was determined by the test.

The friction test was carried out using a ball-on-disk type abrasion tester 11, illustrated in Figure 2, to find friction coefficient and breaking-away load of the high-hardness carbon coating (or abrasive load of the substrate in Comparative Example 1).

The test piece 1 was set on a work table 13 rotating around a shaft 12, and a metallic ball 14 (diameter: 6mm, high-carbon chromium bearing steel, JIS SUJ2 ball) was set as the other material on the test piece 1. The ball was of steel for bearings.

In the tester, the ball was pressed by a spring 15 to the test piece 1 under a load P, which was increased stepwise by 98 N at intervals of 1 minute in a range from 98 to 2452 N.

The metallic ball 14 was held by a holder 16 not to rotate. The shaft 12 was driven by a motor 17 to rotate at a slip velocity of 30 mm/second relative to the metallic ball 14, and a torque corresponding to frictional force evolving between the ball 14 and test piece 1 was measured by a load cell 18 to find friction coefficient.

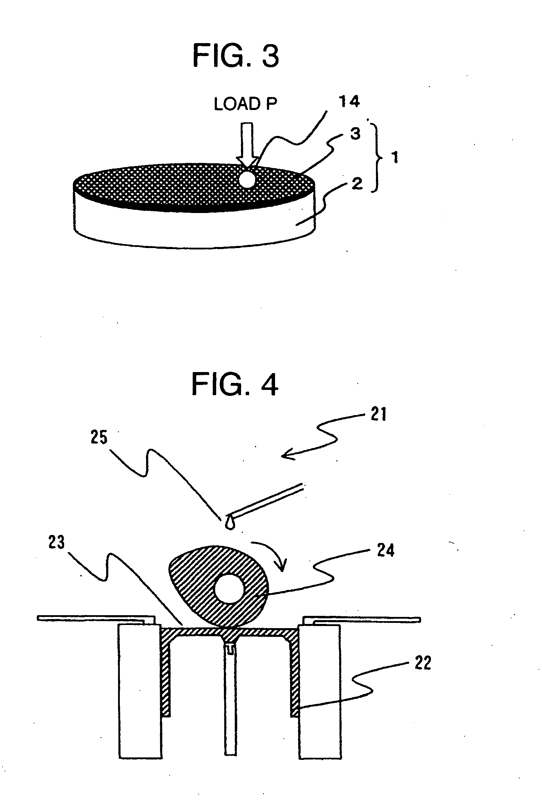

The ball was set at a radius of 8 mm from the test piece center, as illustrated in Figure 3.

The breaking-away load of the high-hardness carbon coating (or abrasive load of the substrate in Comparative Example 1) was a test load at which friction coefficient between the test piece 1 and metallic ball 14 started to sharply increase. The rubbing test was carried out under an unlubricated condition at normal temperature and humidity (room temperature: about 25°C, and humidity: about 60% RH).

### Example 1

The circular substrate 2 of a metal alloy containing Fe, Cr and Mo (Cr-Mo steel, JIS SCM415) was carburized to have a surface hardness HRC (found by a Rockwell hardness test, scale C) of 58 or more and dressed to have a surface roughness (Ra) of 0.1 µm or less.

The high-hardness carbon coating film 3 (hereinafter referred simply as "coating") was formed by the UBM sputtering method in the presence of an inert gas and hydrocarbon gas to have an aluminum content of 0.65% by atom.

The coating 3 had an Ra of 0.021 µm, Young's modulus of 65.94 GPa, friction coefficient of 0.052 (found by the rubbing test with the coating 3 and metallic ball 14), and breaking-away load of 2452 N or more.

The coating prepared in Example 1 had a friction coefficient of 0.1 or less, when slid under an unlubricated condition, which is about 87 to 95% lower than that observed between uncoated steel test pieces or common surface treatment materials, and about 57% lower than that of a conventional coating. It is also found that the coating can exhibit its low-friction characteristics because of its high breaking-away load of 490 N or more.

The coating prepared in Example 1, when applied to a machinery slide member working under an unlubricated condition, can reduce load associated with the slide member in the machinery, realizing a machinery of high energetic efficiency (energy efficiency).

The coating prepared in Example 1 is for a slide member working under an unlubricated condition, and can improve reliability of a machinery in which the slide member works under a lubricated condition, when the lubricant oil is depleted. Moreover, it can reduce lubricant oil consumption, realizing an environment-friendly machinery.

Still more, the coating prepared in Example 1 can exhibit its low-friction characteristics because of its high breaking-away load to keep the substrate coated.

The coating prepared in Example 1 is a high-hardness film of a mixture of sp² bonded carbon represented by graphite and sp³ bonded carbon represented by diamond.

The coating contains aluminum present both in the surface layer and inside at 0.5 to 4.5% by atom, preferably 0.6 to 1.9% by atom.

The composition simultaneously provides the coating with peel resistance and low friction coefficient, even under an unlubricated condition.

The high-hardness carbon coating is a film of amorphous or hydrogenated carbon, referred to as amorphous carbon, hydrogenated amorphous carbon (a-C:H) or diamond-like carbon (DLC).

The film is produced by UBMS.

The coating prepared in Example 1 exhibits low friction characteristics and is applicable to a slide member. Therefore, it can provide a slide member capable of reducing load even under an unlubricated condition. Moreover, the slide member normally working under a lubricated condition can keep its reliability, when the lubricant oil is depleted, thus reducing lubricant oil consumption.

Aluminum exposed to the coating surface reacts with oxygen or moisture in air to form the oxide or hydroxide, and can provide a dielectric coating which stably exhibits electric characteristics, in spite of the presence of aluminum inside.

Aluminum in the surface layer is present in the form of oxide or hydroxide, by which is meant that the surface is hydrophilic and can bring merits of reducing friction on a slide member working in the presence of moisture, or liquid or vapor having the same OH group as water, e.g., alcohol or the like.

A phenomenon is found in Example 1 that presence of aluminum in the coating reduces internal stresses, making it resistant to breaking-away from the substrate.

At an aluminum content below 0.5% by atom, the friction-reducing effect is no longer expected, because of insufficient quantity of aluminum oxide and/or hydroxide which make the surface hydrophilic.

At a content above 5% by atom in the surface layer or inside, on the other hand, aluminum carbide is produced at an excessive rate, as presumed based on X-ray photoelectron spectroscopy (XPS) results. In other words, a content above 5% by atom is undesirable, because of excessive formation of aluminum carbide to cause embrittlement of the carbide and reduce resistance of the coating to cracking.

Aluminum carbide increases coating Young's modulus. The coating loses cracking resistance or peel resistance at a Young's modulus above 180 GPa, and loses resistance of the coating to load in a sliding motion at below 50 GPa.

Aluminum in the coating, in particular when present in the form of the oxide or hydroxide, can reduce friction on the coating because of its affinity for a liquid or vapor having OH group.

Thickness of the coating beyond a range from 0.5 to 10 µm is undesirable. The coating tends to be worn by attrition in a sliding motion when it is thinner than 0.5 µm, whereas it tends to break away from the substrate when it is thicker than 10 µm because of excessive stresses evolving inside. The coating has a high-hardness surface, and tends to wear the other member with which it is in contact, when its surface roughness increases beyond 0.1 µm.

The coating is produced by UBMS.

The intended target areas for the coating prepared in Example 1 are those required to have durability, e.g., slide members in vehicles, in particular engine cylinders, and refrigerant compressor and rotary compressor vanes for refrigerators, air conditioners and so forth.

### Example 2

The circular substrate 2 of JIS SCM415 was carburized to have a surface hardness HRC of 58 or more, dressed to have a surface roughness Ra of 0.1 µm or less, and coated with the coating 3 by the UBM sputtering method in the presence of an inert gas and hydrocarbon gas in such a way to contain aluminum at 0.67% by atom.

The coating 3 had an Ra of 0.019 µm, Young's modulus of 164.6 GPa, friction coefficient of 0.090, found by the rubbing test with the coating 3 and metallic ball 14, and breaking-away load of 981 N.

The coating prepared in Example 2 had a friction coefficient of 0.1 or less, when slid under an unlubricated condition, which is about 77 to 91% lower than that observed between uncoated steel test pieces or common surface treatment materials, and about 25% lower than that of a conventional coating. Moreover, it can exhibit its low-friction characteristics because of its high breaking-away load of 490 N or more.

The coating prepared in Example 2, when applied to a machinery slide member working under an unlubricated condition, can reduce load associated with the slide member in the machinery, realizing a machinery of high energy efficiency. Moreover, it is for a slide member working under an unlubricated condition, and can improve reliability of a machinery in which the slide member works under a lubricated condition, when the lubricant oil is depleted. Still more, it can reduce lubricant oil consumption, realizing an environment-friendly machinery.

### Example 3

The circular substrate 2 of JIS SCM415 was carburized to have a surface hardness HRC of 58 or more, dressed to have a surface roughness Ra of 0.1 µm or less, and coated with the coating 3 by the UBM sputtering method in the presence of an inert gas and hydrocarbon gas in such a way to contain aluminum at 1.88% by atom.

The coating 3 had an Ra of 0.021 µm. Young's modulus of 158.7 GPa, friction coefficient of 0.046, found by the rubbing test with the coating 3 and metallic ball 14, and breaking-away load of 588 N.

The coating prepared in Example 3 had a friction coefficient of 0.1 or less, when slid under an unlubricated condition, which is about 88 to 96% lower than that observed between uncoated steel test pieces or common surface treatment materials, and about 62% lower than that of a conventional coating. Moreover, it can exhibit its low-friction characteristics because of its high breaking-away load of 490 N or more.

The coating prepared in Example 3, when applied to a machinery slide member working under an unlubricated condition, can reduce load associated with the slide member in the machinery, realizing a machinery of high energy efficiency. Moreover, it is for a slide member working under an unlubricated condition, and can improve reliability of a machinery in which the slide member works under a lubricated condition, when the lubricant oil is depleted. Still more, it can reduce lubricant oil consumption, realizing an environment-friendly machinery.

A vehicle lifter 22 of JIS SCM415 at valve operation system 22 was carburized on a crest surface 23 to have a surface hardness HRC of 58 or more, dressed to have a surface roughness Ra of 0.1 µm or less, and coated with the coating of Example 3 by the UBM sputtering method in the presence of an inert gas and hydrocarbon gas. A cam 24 was rotated under an oil-lubricated condition to slide on the lifter to evaluate the coating by friction torque and durability using a simulation tester 21 illustrated in Figure 4. In the test, the cam 24 was rotated at 300 rpm while it was lubricated with an engine oil 25 (SAE 5W-30) applied dropwise, to measure torque on the cam shaft 2 hours after the test was started. The tested coating was observed to confirm whether it was peeled or not.

The test results indicated that the coating reduced torque by about 47% from that associated with an uncoated lifter of the same material, showing no peel of the coating.

The coating prepared in Example 3, when applied to the vehicle cam lifter 22, can reduce torque and hence sliding load with the cam 24. Moreover, it can continuously exhibit its low friction characteristics because of its high peel resistance, and realize vehicles running at high energy efficiency for extended periods.

### Example 4

The circular substrate 2 JIS SCM415 was carburized to have a surface hardness HRC of 58 or more, finished to have a surface roughness Ra of 0.1 µm or less, and coated with the coating 3 by the UBM sputtering method in the presence of an inert gas and hydrocarbon gas in such a way to contain aluminum at 4.14% by atom.

The coating 3 had an Ra of 0.020 µm, Young's modulus of 80.63 GPa, friction coefficient of 0.093, found by the rubbing test with the coating 3 and metallic ball 14, and breaking-away load of 1079 N.

The coating prepared in Example 4 had a friction coefficient of 0.1 or less, when slid under an unlubricated condition, which is about 77 to 91% lower than that observed between uncoated steel test pieces or common surface treatment materials, and about 22% lower than that of a conventional coating. Moreover, it can exhibit its low-friction characteristics because of its high breaking-away load of 490 N or more.

The coating prepared in Example 4, when applied to a machinery slide member working under an unlubricated condition, can reduce load associated with the slide member in the machinery, realizing a machinery of high energy efficiency. Moreover, it is for a slide member working under an unlubricated condition, and can improve reliability of a machinery in which the slide member works under a lubricated condition, when the lubricant oil is depleted. Still more, it can reduce lubricant oil consumption, realizing an environment-friendly machinery.

### Comparative Example 1

The circular substrate 2 of JIS SCM415 was carburized to have a surface hardness HRC of 58 or more and dressed to have a surface roughness Ra of 0.1 µm or less. It was not coated with a high-hardness carbon coating.

The substrate 2 had an Ra of 0.015 µm, Young's modulus of 323.8 GPa, friction coefficient of 0.516, found by the rubbing test with the coating 3 and metallic ball 14, and abrasive load of 98 N.

The uncoated substrate 2 prepared in Comparative Example 1 fails to have a decreased friction coefficient, when slid under an unlubricated condition, because of sliding of uncoated steel members on each other. When applied to a machinery slide member, it can neither reduce load associated with the slide member in the machinery, nor realize a machinery of high energy efficiency. Moreover, it cannot improve reliability of a machinery in which the slide member works under a lubricated condition, when the lubricant oil is depleted. Still more, it cannot reduce lubricant oil consumption, failing to realize an environment-friendly machinery.

### Comparative Example 2

The circular substrate 2 of JIS SCM415 was carburized to have a surface hardness HRC of 58 or more, dressed to have a surface roughness Ra of 0.1 µm or less, and coated with the coating 3 by the UBM sputtering method in the presence of an inert gas and hydrocarbon gas in such a way to contain aluminum at 0.10% by atom.

The coating 3 had an Ra of 0.019 µm, Young's modulus of 74.13 GPa, friction coefficient of 0.133, found by the rubbing test with the coating 3 and metallic ball 14, and breaking-away load of 2452 N or more.

The coating prepared in Comparative Example 2, when applied to a machinery slide member working under an unlubricated condition, cannot decrease a friction coefficient to a level lower than that of a conventional coating, although showing high peel resistance. Therefore, it can not realize an environment-friendly machinery in which the slide member works under an unlubricated condition.

A vehicle lifter of JIS SCM415 at valve operation system 22 was carburized on a crest surface 23 to have a surface hardness HRC of 58 or more, dressed to have a surface roughness Ra of 0.1 µm or less, and coated with the coating of Comparative Example 2 by the UBM sputtering method in the presence of an inert gas and hydrocarbon gas. It was evaluated by the procedures in the same manner as in Example 3.

The test results indicated that the coating reduced torque by about 43% from that commonly associated with an uncoated lifter of the same material, although partly peeling away from the crest surface.

The coating prepared in Comparative Example 2, when applied to the vehicle cam lifter 22, can reduce torque and hence sliding load with the cam 24. However, it cannot continuously exhibit its low friction characteristics because it partly peeled away from the lifter 22, failing to realize vehicles running at high energy efficiency for extended periods.

### Comparative Example 3

The circular substrate 2 of JIS SCM415 was carburized to have a surface hardness HRC of 58 or more, dressed to have a surface roughness Ra of 0.1 µm or less, and coated with the coating 3 by the UBM sputtering method in the presence of an inert gas and hydrocarbon gas in such a way to contain aluminum at 5.94% by atom.

The coating 3 had an Ra of 0.021 µm, Young's modulus of 193.0 GPa, friction coefficient of 0.602, found by the rubbing test with the coating 3 and metallic ball 14, and breaking-away load of 98 N.

The high-hardness carbon coating prepared in Comparative Example 3, when slid under an unlubricated condition, cannot decrease a friction coefficient to a level lower than that observed between uncoated steel test pieces or common surface treatment materials. Therefore, it can neither reduce load associated with the slide member in the machinery, nor realize a machinery of high energy efficiency. Moreover, it is not intended for sliding under an unlubricated condition, and hence cannot improve reliability of a machinery in which the slide member works under a lubricated condition, when the lubricant oil is depleted. Still more, it cannot reduce lubricant oil consumption, failing to realize an environment-friendly machinery.

### Comparative Example 4

The circular substrate 2 of JIS SCM415 was carburized to have a surface hardness HRC of 58 or more, dressed to have a surface roughness Ra of 0.1 µm or less, and coated with the coating 3 by the UBM sputtering method in the presence of an inert gas and hydrocarbon gas in such a way to contain aluminum at 11.52% by atom.

The coating 3 had an Ra of 0.019 µm, Young's modulus of 80.90 GPa, friction coefficient of 0.080, found by the rubbing test with the coating 3 and metallic ball 14, and breaking-away load of 392 N.

The high-hardness carbon coating prepared in Comparative Example 4, when slid under an unlubricated condition, has a low friction coefficient, although insufficient in peel resistance. It can work efficiently in a sliding service in a low load range, but may not in a high load range.

In other words, it cannot reduce load in a machinery at a slide member on which it is provided, and is difficult to realize a machinery of high energy efficiency. Moreover, it has a limited effect of reducing lubrication oil consumption, and cannot realize environment-friendly machineries.

**Table 1**

| | Coating | Coating method | Al contents | Thickness of coating [µm] | Young's modulus [GPa] | Ra [µm] | Friction coefficient µ | Breaking-away load (abrasive load) [N] * |
|---|---|---|---|---|---|---|---|---|
| Example 1 | DLC | UBM sputtering | 0.65 at% | 1.4 | 65.94 | 0.021 | 0.052 | 2452 or more |
| Example 2 | DLC | UBM sputtering | 0.67 at% | 1.3 | 164.6 | 0.019 | 0.090 | 981 |
| Example 3 | DLC | UBM sputtering | 1.88 at% | 1.3 | 158.7 | 0.021 | 0.046 | 588 |
| Example 4 | DLC | UBM sputtering | 4.14 at% | 1.4 | 80.63 | 0.020 | 0.093 | 1079 |
| Comparative Example 1 | none | - | - | - | 323.8 | 0.015 | 0.516 | 98 |
| Comparative Example 2 | DLC | UBM sputtering | 0.10 at% | 1.4 | 74.13 | 0.019 | 0.133 | 2452 or more |
| Comparative Example 3 | DLC | UBM sputtering | 5.94 at% | 1.2 | 193.0 | 0.021 | 0.602 | 98 |
| Comparative Example 4 | DLC | UBM sputtering | 11.52 at% | 1.4 | 80.90 | 0.019 | 0.088 | 392 |

| | | | | | | | | |
|---|---|---|---|---|---|---|---|---|
| * Breaking-away load in Examples 1 to 4 and Comparative Examples 2 to 4, and abrasive load in Comparative Example 1. | | | | | | | | |

### Industrial Applicability

The present invention relates to a high-hardness carbon coating useful for slide members working under an unlubricated condition, in the presence of water, organic solvent or fuel, or under an oil-lubricated condition.

It should be further understood by those skilled in the art that although the foregoing description has been made on embodiments of the invention, the invention is not limited thereto and various changes and modifications may be made without departing from the scope of the appended claims.

### Advantages of the Invention

The present invention can provide a high-hardness carbon coating which can exhibit its inherent rub resistance.

## Claims

1. A method for producing a slide member, comprising the steps of
forming on a substrate (2) a high-hardness diamond-like carbon coating (3) containing an aluminum element at 0.5 to 4.5% by atom, by unbalanced magnetron sputtering, and
exposing the aluminum element on the coating surface layer to air in order to react with oxygen or moisture in the air to form aluminum oxide and/or aluminum hydroxide.

2. A slide member obtainable by the method of claim 1.

3. The slide member of claim 2, wherein said aluminum element is present both in the surface layer and inside.

4. The slide member of claim 2 which has a Young's modulus of 50 to 180 GPa.

5. The slide member of claim 2, wherein the carbon coating (3) has a thickness of 0.5 to 10.0 µm, and a surface roughness of 0.1 µm or less.

6. The slide member of claim 2, wherein the carbon is a mixture of sp² and sp³ bonded carbon species.

7. The slide member of any preceding claim, wherein the substrate (2) is of a metal alloy containing Fe, Cr and Mo.

8. The slide member of claim 7, further comprising a Cr layer between the substrate (2) and the coating (3).

9. The slide member of claim 8, wherein the Cr layer is further coated with a Cr/C layer in which Cr and C are mixed with each other.

## Patentansprüche

1. Verfahren zum Herstellen eines Gleitelements, in dem
auf einem Substrat (2) eine diamantartige Kohlenstoffbeschichtung (3) hoher Härte mit einem Aluminiumelement von 0,5 bis 4,5 Atom-% durch Unbalanced-Magnetron-Sputtering gebildet wird, und
das Aluminiumelement der Beschichtungsoberflächenschicht Luft ausgesetzt wird, um eine Reaktion mit Sauerstoff oder Feuchtigkeit in der Luft zu bewirken, so dass Aluminium-Oxid und/oder Aluminium-Hydroxid gebildet wird.

2. Gleitelement, dass durch das Verfahren nach Anspruch 1 erhältlich ist.

3. Gleitelement nach Anspruch 2, wobei das Aluminiumelement sowohl in der Oberflächenschicht als auch im Inneren vorhanden ist.

4. Gleitelement nach Anspruch 2, das ein Young-Modul von 50 bis 180 GPa aufweist.

5. Gleitelement nach Anspruch 2, wobei die Kohlenstoffbeschichtung (3) eine Dicke von 0,5 bis 10,0 µm und eine Oberflächenrauhigkeit von höchstens 0,1 µm aufweist.

6. Gleitelement nach Anspruch 2, wobei der Kohlenstoff eine Mischung von sp²- und sp³-gebundenen Kohlenstoffarten ist.

7. Gleitelement nach einem der vorstehenden Ansprüche, wobei das Substrat (2) aus einer Metalllegierung ist, die Fe, Cr und Mo enthält.

8. Gleitelement nach Anspruch 7, ferner mit einer Cr-Schicht zwischen dem Substrat (2) und der Beschichtung (3).

9. Gleitelement nach Anspruch 8, wobei die Cr-Schicht ferner mit einer Cr/C-Schicht beschichtet ist, in der Cr und C miteinander vermischt sind.

## Revendications

1. Procédé pour produire un élément coulissant, comportant les étapes consistant à :
former sur un substrat (2) un revêtement en carbone en forme de diamant à dureté élevée (3) contenant un élément en aluminium à 0,5 à 4,5 % par atome, par pulvérisation à magnétron déséquilibré, et
exposer l'élément en aluminium sur la couche de surface de revêtement à l'air afin de le faire réagir avec de l'oxygène ou de l'humidité dans l'air pour former un oxyde d'aluminium et/ou un hydroxyde d'aluminium.

2. Élément coulissant pouvant être obtenu par le procédé de la revendication 1.

3. Élément coulissant selon la revendication 2, dans lequel ledit élément en aluminium est présent à la fois dans la couche de surface et à l'intérieur.

4. Élément coulissant selon la revendication 2 lequel a un module de Young de 50 à 180 GPa.

5. Élément coulissant selon la revendication 2, dans lequel le revêtement en carbone (3) a une épaisseur comprise entre 0,5 et 10,0 µm, et une rugosité de surface de 0,1 µm ou inférieure.

6. Élément coulissant selon la revendication 2, dans lequel le carbone est un mélange d'espèces de carbone sp² et sp³ liées.

7. Élément coulissant selon l'une quelconque des revendications précédentes, dans lequel le substrat (2) est un alliage métallique contenant Fe, Cr et Mo.

8. Élément coulissant selon la revendication 7, comportant en outre une couche de Cr comprise entre le substrat (2) et le revêtement (3).

9. Élément coulissant selon revendication 8, dans lequel la couche de Cr est en outre recouverte d'une couche de Cr/C dans laquelle Cr et C sont mélangés ensemble.
